(19) Europäisches Patentamt
European Patent Office
Office européen des brevets

(11) **EP 1 936 802 B1**

(12) **EUROPÄISCHE PATENTSCHRIFT**

(45) Veröffentlichungstag und Bekanntmachung des Hinweises auf die Patenterteilung:
**13.07.2011 Patentblatt 2011/28**

(51) Int Cl.:
***H03F 3/60*** *(2006.01)*

(21) Anmeldenummer: **07017833.0**

(22) Anmeldetag: **12.09.2007**

(54) **Leistungsbreitbandverstärker**

High performance broadband amplifier

Amplificateur de puissance à large bande

(84) Benannte Vertragsstaaten:
**DE ES FR GB IT**

(30) Priorität: **08.11.2006 DE 102006052611**

(43) Veröffentlichungstag der Anmeldung:
**25.06.2008 Patentblatt 2008/26**

(73) Patentinhaber: **EADS Deutschland GmbH**
**85521 Ottobrunn (DE)**

(72) Erfinder: **Salomon, Andreas**
**85716 Unterschleissheim (DE)**

(74) Vertreter: **Riegel, Werner**
**EADS Deutschland GmbH,**
**Patentabtlg.., DSLAIP1**
**88039 Friedrichshafen (DE)**

(56) Entgegenhaltungen:
**EP-A- 1 521 361       WO-A-00/64048**
**WO-A-2005/088830   DE-A1- 3 709 169**
**DE-B1- 2 807 813     JP-A- 2 111 111**
**US-A- 4 656 434       US-A1- 2004 189 380**
**US-A1- 2006 145 761  US-B1- 6 496 061**

**Beschreibung**

Die Erfindung betrifft eine Schaltung zur Breitbandverstärkung gemäß den Merkmalen des Oberbegriffs des Patentanspruchs 1.

Aus DE 37 09 169 A1 und US 2004/189380 A1 sind ein Antennenkoppler bekannt, welcher einen dem Oberbergriff des Anspruchs 1 ähnlichen Aufbau aufweist. Bei dem Antennenkoppler ist ein erster 90° -Hybridkoppler mit dem Eingang des Antennenkopplers und ein zweiter 90°-Hybridkoppler mit dem Ausgang des Antennenkopplers verbunden. Zwischen dem ersten und dem zweiten Hybridkoppler sind zwei Sperrfilter parallel geschaltet, wobei jeder Sperrfilter jeweils mit einem Phasendrehglied in Reihe geschaltet ist. Bei diesem Antennenkoppler ist die Bandbreite des zu übertragenden Signals von der Bandbreite der jeweiligen 90°-Hybridkoppler abhängig. Eine Breitbandverstärkung ist mit dem bekannten Antennenkoppler nicht möglich.

Lineare Breitbandverstärker (Klasse A) finden vornehmlich in der Messtechnik als Messverstärker Einsatz. Hierbei werden mehrere breitbandig angepasste Transistorstufen zu einem Gesamtverstärker hintereinandergeschaltet. Die jeweiligen Transistoren erhalten dabei einen geeigneten Ruhestrom, um den Arbeitspunkt für einen linearen Verstärkerbetrieb zu gewährleisten. Die vornehmlich genutzte Halbleitertechnologie für diese Verstärker ist GaAs. Diese Messverstärker arbeiten üblicherweise sehr linear. Allerdings weisen diese Messverstärker einen beschränken Frequenzbereich auf und sind in der Sättigungsleistung begrenzt.

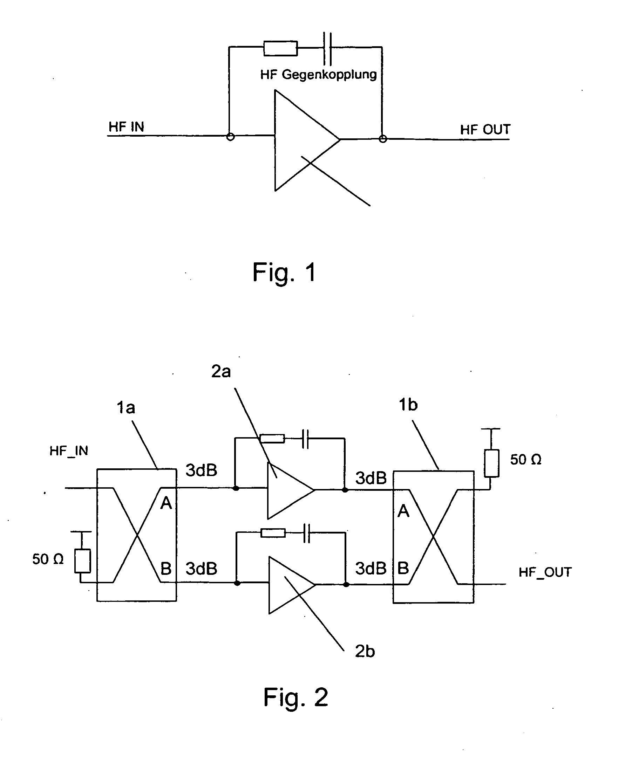

Zur Verbesserung der breitbandigen Anpassung der Einzelverstärkerstufen wird mit einer HF-Gegenkopplung (RC-Glied) zwischen dem HF-Eingang und -Ausgang gearbeitet. Diese HF-Gegenkopplung soll bei niedrigen Frequenzen eine wachsende Schwingneigung der HF-Transistoren bedämpfen, hervorgerufen durch deren erhöhte Verstärkungscharakteristik (Fig.1). Ebenso sorgt die HF-Gegenkopplung für ein gleichmäßiges Verstärkungsverhalten über einen sehr weiten Frequenzbereich. Ein Verlust an Verstärkung wird dabei in Kauf genommen.

Zur Verbesserung der Eingangsanpassung werden breitbandige 90°-Hybridkoppler verwendet (Fig. 2). Außerdem kommt für jede Verstärkerstufe üblicherweise eine HF-Gegenkopplung zum Einsatz. Dadurch wird die Eingangsanpassung über den Frequenzbereich der 90° Hybridkoppler verbessert. Außerdem wird die Sättigungsleistung des Verstärkers erhöht.
Eine Schaltungsanordnung zur Erreichung von Leistungsanpassung bei rauschangepassten Hochfrequenz-Verstärkern ist aus DE 28 07 813 B1 bekannt.

Die Funktionsweise eines 3 dB 90°-Hybridkopplers ist bekannt. Ein 90° Hybridkoppler wirkt, wie der Name schon sagt, wie ein Richtkoppler der jeweils die Hälfte der eingespeisten HF-Leistung an zwei HF-Ausgänge aufteilt. Die HF-Signale an diesen zwei HF-Ausgängen besitzen dabei einen Phasenunterschied von 90°. Wird HF-Leistung wieder in die 3dB-Ausgänge zurückreflektiert, so findet nur am isolierten Ausgang eine Addition der HF-Leistung statt. An diesem Punkt kann die reflektierte HF-Leistung mit einem Abschlusswiderstand in Wärme umgesetzt werden. An den Eingang des 90° Hybridkopplers kann somit keine reflektierte HF-Leistung zurückkommen, was zu einer erheblichen Verbesserung des Eingangs-Stehwellenverhältnisses VSWR der Gesamtschaltung führt.

Breitbandige 90°-Hybridkoppler sind in ihren Abmessungen allerdings sehr groß. Die Firma Anaren bietet einen 90° Hybrid Koppler an, der über einen Frequenzbereich von 500 MHz bis 3,0 GHz HF-Leistungen bis 100 Watt cw verträgt.

Allerdings sind von ca. 15 x 3,5 x 1 cm zu groß für eine Entwicklung von kleinen und kompakten Sendern. Obwohl vom physikalischen Aspekt fast keine Verkleinerung eines solchen Kopplers machbar ist, besteht doch der Wunsch die Größe zu reduzieren.

Des Weiteren sind breitbandige Hybridkoppler in ihrer maximal zulässigen Leistung auf geringere Leistungsniveaus begrenzt.

Verstärker gemäß dem Oberbegriff des Patentanspruchs 1 sind u.a. von der Fa. Kuhne Electronic bekannt  (www.kuhne-electronic.de/german/vorverstaerker.html). Diese Verstärker weisen allerdings eine Verstärkung mit einer Bandbreite von weniger als eine Oktave auf.

Im weiteren wird unter dem Begriff Bandbreite die Größe des Frequenzbereichs verstanden, den ein Signal zwischen seiner unteren und oberen Grenzfrequenz belegt. Des Weiteren wird unter dem Begriff Oktave ein Intervall mit einem Frequenzverhältnis von 2:1 zwischen einem oberen Frequenzwert und einem unteren Frequenzwert verstanden.

Es ist Aufgabe der Erfindung eine kompakte Schaltung zur Breitbandverstärkung anzugeben, mit welcher eine Bandbreitenverstärkung von mehr als 1 Oktave möglich ist.

Diese Aufgabe wird mit dem Breitbandverstärker gemäß den Merkmalen des Anspruchs 1 gelöst. Vorteilhafte Ausführungen der Erfindung sind Gegenstand von Unteransprüchen.

Die Aufgabe wird gelöst durch die Merkmale des Patentanspruchs 1. In der erfindungsgemäßen Schaltung kommen 90°-Hybridkoppler zum Einsatz, welche einen Arbeitsbereich von 1/n Oktaven zwischen einem unteren Frequenzwert und einem oberen Frequenzwert aufweisen, wobei $n \in \mathbb{N} \setminus \{0\}$ ist, d.h. n ist ein Element der natürlichen positiven ganzen Zahlen. Mit anderen Worten der obere Frequenzwert des Arbeitsbereichs größer als der untere Frequenzwert und gleichzeitig kleiner als oder gleich dem 2-Fachen Wert des unteren Frequenzwertes.
Ein 90°-Hybridkoppler mit einem solchen Arbeitsbereich wird im Weiteren auch als schmalbandiger Hybridkoppler bezeichnet. Im Gegensatz zu einem breitbandigen Hybridkoppler, welcher einen Arbeitsbereich aufweist mit einem oberen Frequenzwert, welcher größer ist als der 2-Fache Wert des unteren Frequenzwertes des Arbeitsbereichs.

Die Erfindung ermöglicht es, 90°-Hybridkoppler sowohl in SMD-, oder drop in Bauweise, als auch Aluminium Gehäuste 90°-Hybridkoppler einzusetzen. Unter Drop In-Bauelemente versteht der Fachmann ein direkt passendes Ersatzteil, d.h. Ersatz eines bestehenden Bauelementes, Schaltkreises, Moduls etc. innerhalb einer bestehenden Schaltung, durch Einsetzen einer moderneren oder leistungsfähigeren Ausführung, ohne dass hierzu die Infrastruktur der Schaltungsplatine, die Software oder sonst etwas modifiziert werden muss. Unter einem SMD-Bauelement (surface mounted device) versteht der Fachmann ein oberflächenmontierbares Bauelement.

Ein möglicher SMD 90°-Hybridkoppler ist z.B. die Komponente ANAREN XINGER 11306-3 und wird von der Firma ANAREN angeboten. Diese schmalbandigen SMD 90° Hybridkoppler sind für den Mobilfunkmarkt als Massenprodukt verfügbar. Je nachdem wie groß die Bandbreite der Koppler gewählt wird, steigt auch die Leistungsverträglichkeit des Bauteils.

Ein weiteres wesentliches Merkmal der erfindungsgemäßen Schaltung ist, dass die Verstärkerstufen auf Transistoren basieren, die aus Halbleitermaterialien mit großen elektronischen Bandlücken (englisch : bandgap) gefertigt sind. Solche Transistoren werden auch als wide bandgap Transistoren bezeichnet. Solche Transistoren können z.B. auf Basis von III-Nitrid-Halbleitern, z.B. GaN, AIN oder auf Basis von Siliziumcarbid (SiC) oder Diamant gefertigt sein.

Wide Bandgap Transistoren zeichnen sich durch eine im Gegensatz zu herkömmlichen Transistoren, z.B. auf GaAs-Basis (III-V-Halbleiter), durch eine höhere Eingangsimpedanz aus. Anders als bei Transistoren auf GaAs-Basis neigen Wide bandgap Transistoren im Bereich von 100 MHz-500 MHz nicht zu einem Schwingverhalten. Dadurch können Wide Bandgap Transistoren auch in diesem Frequenzbereich als Verstärker eingesetzt werden, wohingegen Transistoren auf GaAs-Basis in diesem Frequenzbereich zum Schwingen neigen.

Die Erfindung wird im Weiteren anhand von Figuren näher erläutert. Es zeigen:

Fig. 1: den Grundaufbau einer HF-Gegenkopplung,

Fig. 2: den Aufbau einer Verstärkerschaltung mit 90°-Hybridkopplern und mit parallel geschalteten Verstärkerstufen mit HF-Gegenkopplung,

Fig. 3: den Verlauf der frequenzabhängigen Verstärkung einer Transistorverstärkerstufe mit Wide Bandgap-Transistoren ohne HF-Gegenkopplung,

Fig. 3a: Eingangs-Return Loss S11 der beispielhaften Transistoren PTF240PD (GaN) und CRF24010 (SiC),

Fig. 3b: Eingangs- Return Loss der erfindungsgemäßen Verstärkerschaltung nach Fig. 6,

Fig. 4: den Verlauf der Dämpfung der Reihenschaltung zweier schmalbandiger 90°-Hybridkoppler (hier Typ XINGER 11306-3; 2.0 GHz - 4.0 GHz),

Fig. 5: den Verlauf einer additiven Überlagerung der Fig. 3 und Fig. 4,

Fig. 6: den Aufbau einer erfindungsgemäßen Schaltung,

Fig. 7: den Verlauf der Einkopplung der HF-Eingangsleistung auf die parallelen Verstärkerzüge einer erfindungsgemäßen Schaltung, bedingt durch den 90°-Hybridkoppler 1a in Fig. 6.

Fig. 1 zeigt eine bereits oben beschriebene Transistorverstärkerstufe eines linearen Breitbandverstärkers mit HF-Gegenkopplung. Hierbei werden mehrere breitbandig angepasste Transistorstufen 2 zu einem Gesamtverstärker hintereinandergeschaltet. Die jeweiligen Transistoren erhalten dabei einen geeigneten Ruhestrom, um den Arbeitspunkt für einen linearen Verstärkerbetrieb zu gewährleisten. Die vornehmlich genutzte Halbleitertechnologie für diese Verstärker ist GaAs.

Fig. 2 zeigt den Aufbau einer Verstärkerschaltung mit 90°-Hybridkopplern. Durch die Verwendung breitbandiger 90°-Hybridkoppler 1 a, 1 b wird die Eingangsanpassung der Hybridkoppler 1 a, 1 b über ihren jeweiligen Arbeitsfrequenzbereich verbessert. Zwischen den beiden Hybridkopplern 1 a, 1 b sind zwei Verstärkerstufen 2a, 2b parallel geschaltet. Jede Verstärkerstufe 2a, 2b weist dabei eine HF-Gegenkopplung auf. Das zu verstärkende Signal wird der Schaltung am Eingang HF_IN zugeführt. Am Ausgang HF_OUT liegt das verstärkte Signal an, welches beispielsweise an eine Antenne geführt wird.

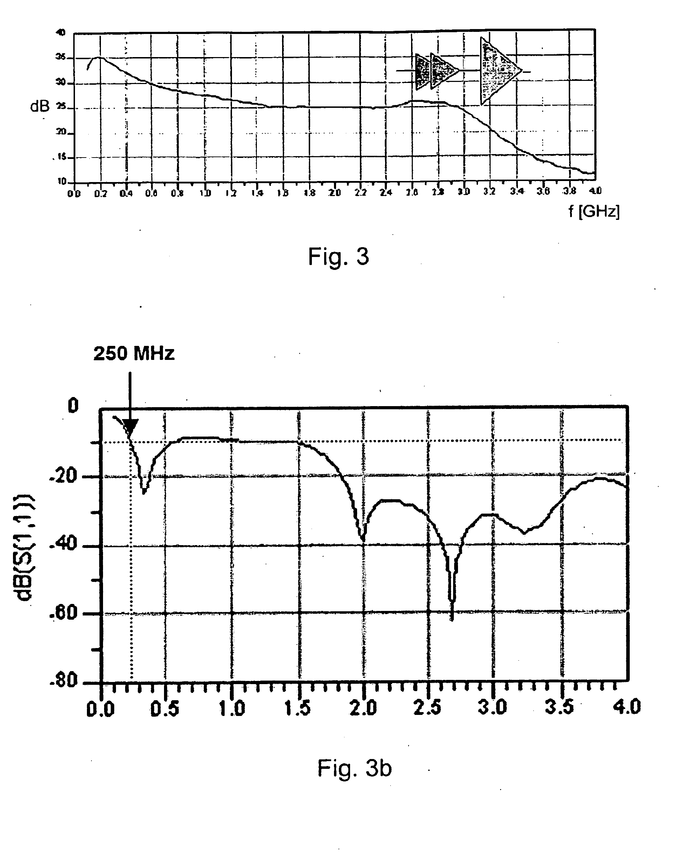

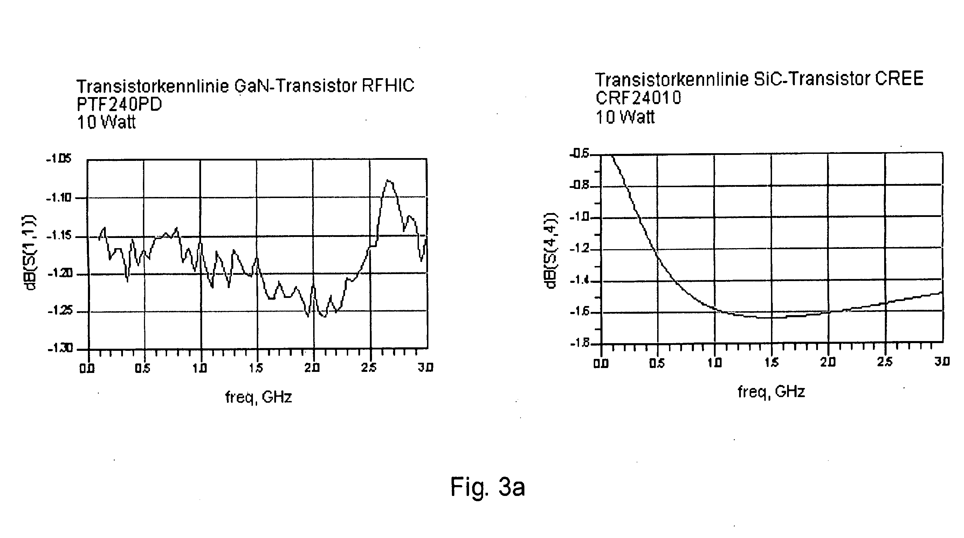

Fig. 3 zeigt den beispielhaften Verlauf der frequenzabhängigen Verstärkung einer Transistorverstärkerstufe mit Wide Bandgap-Transistoren ohne HF-Gegenkopplung. In dieser Darstellung ist beispielhaft der frequenzabhängige Verlauf der Verstärkung einer Transistorverstärkerstufe mit einem GaN-Transistor, Typ RT240PD der Fa. RFHIC dargestellt. Die Verstärkung liegt im Bereich von 1,5 GHz bis 3,0 GHz bei ca. 25 dB. Unterhalb von 1,5 GHz ist die Transistorverstärkerstufe geeignet angepasst, so dass die Verstärkung in diesem Bereich oberhalb 25 dB liegt.

Typischerweise zeigen Wide Bandgap- Transistoren nur sehr geringe Return Loss Werte (S11) über den gewünschten Frequenzbereich (Fig. 3a). Der GaN-Transistor vom Typ PTF240PD weist Werte von 1,1 dB<S11<1,25 dB auf (linke Darstellung in Fig. 3a). Der SiC-Transistor vom Typ CRF24060 zeigt ein Eingangs-Return Loss von 0,65 dB <S11 <0,90 dB über den Frequenzbereich von 100 MHz - 3,0 GHz (rechte Darstellung in Fig. 3a). Dieser Umstand von sehr niedrigen S11-Werten erschwert die Integration dieser Transistoren in eine Verstärkerkette, da die Ausgangsleistung von vorherigen Verstärkerkomponenten in einer Verstärkerkette am Eingang des Wide Bandgap-Transistors wieder hauptsächlich zurückreflektiert wird. Dies kann zur Zerstörung der vorigen Verstärkerkomponenten führen.

Die Verwendung eines 90° Hybridkopplers verbessert das Eingangs-Return Loss auf Werte von S11 > 10 dB über einen Frequenzbereich von 250 MHz - 3,0 GHz (Fig. 3b). Somit eignet sich eine Verstärkerkonstruktion mit 90°-Hybridkopplern besser als integrierbare Systemkomponente.

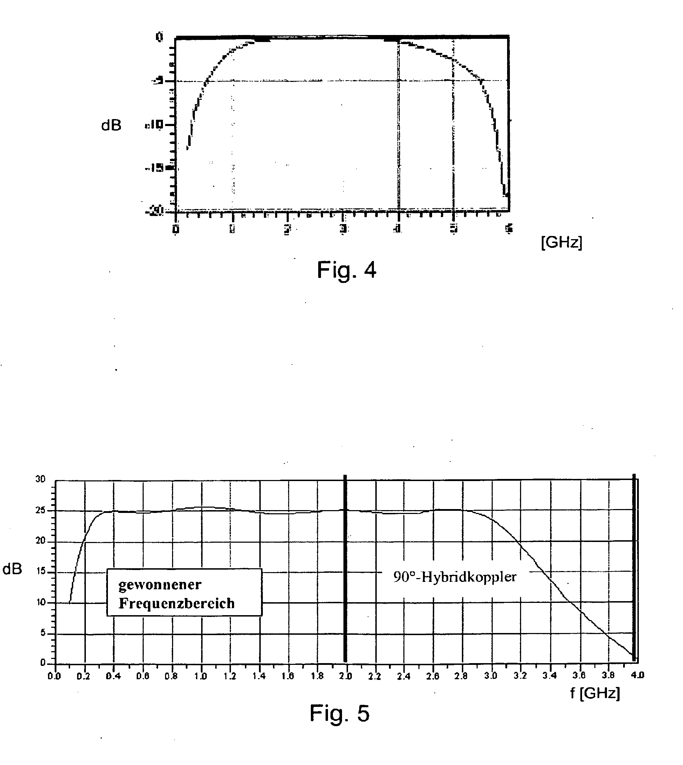

Fig. 4 zeigt den frequenzabhängigen Verlauf der Verstärkung zweier in Reihe geschalteter schmalbandiger 90°-Hybridkoppler vom Typ 11306-3 der Fa. ANAREN XINGER.

Die schmalbandigen 90°-Hybridkoppler arbeiten im Frequenzbereich von 2,0-4,0 GHz bei konstantem Koppelfaktor von 3dB. Ebenso ist die Phasenstabilität von 90° gewährleistet. Die Verstärkungsverluste in diesem Frequenzbereich sind gering. Unterhalb von 2,0 GHz und oberhalb von 4,0 GHz steigt die Dämpfung der Hybridkoppler allerdings stark an.

Fig. 3 zeigt zudem, dass die Transistorverstärkerstufe geeignet angepasst ist. Das Ein- und Ausgangsanpassungsnetzwerk der jeweiligen Transistoren wird durch Mikrostreifenleitungen realisiert, die in geeigneter Weise eine Kombination aus Induktivitäten und Kapazitäten darstellt, um den gewünschte Verstärkungsverlauf über den gesamten Frequenzbereich zu erhalten. Die Gestaltung eins Anpassungsnetzwerkes ist eine einem Fachmann geläufige Maßnahme.

Im Bereich von 100 MHz bis 2,0 GHz, also über einen Frequenzbereich von ca. 5 Oktaven, weist die Transistorverstärkerstufe eine Verstärkung auf, welche die Dämpfung der schmalbandigen 90°-Hybridkoppler kompensiert. Zweckmäßig ist die Transistorverstärkerstufe derart angepasst, dass in einem oder mehreren vorgebbaren Frequenzbereichen, in welchen die 90°-Hybridkoppler Dämpfungswerte von größer als 3 dB aufweisen, die Verstärkung der Verstärkerstufen diese Dämpfungswerte kompensieren, so dass am Ausgang der Schaltung die Verstärkung in einem Frequenzbereich von k Oktaven innerhalb eines vorgebbaren Wertebereichs liegt, wobei $k \in \mathbb{N} \setminus \{0\}$ ist.

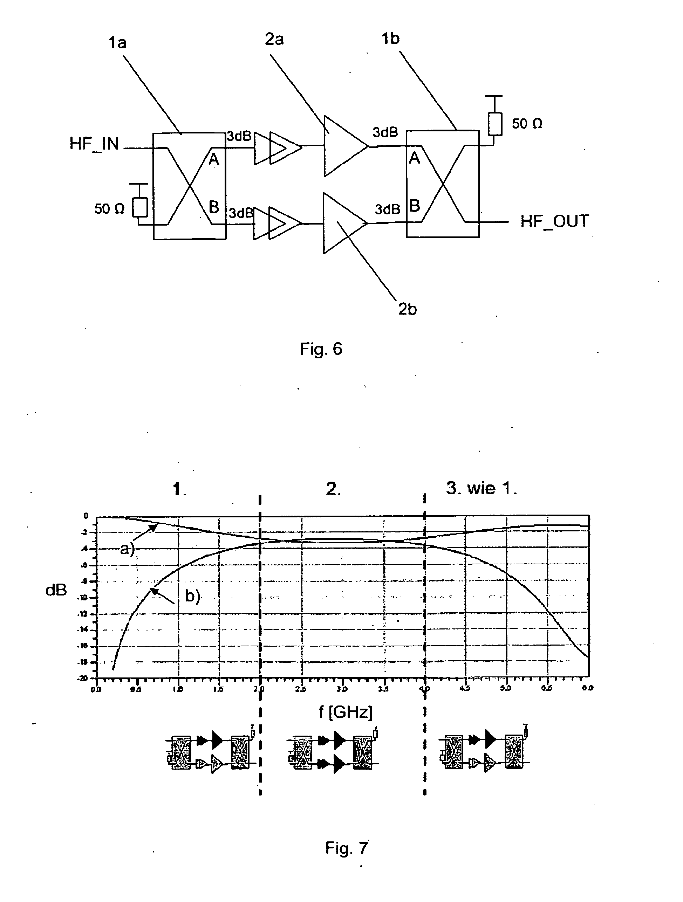

In Fig. 5 ist der frequenzabhängige Verlauf der Verstärkung einer erfindungsgemäßen Schaltung in Fig. 6 dargestellt- Der frequenzabhängige Verstärkungsverlauf in Fig. 5 ist die additive Verknüpfung der in Fig. 3 und 4 dargestellten Verstärkungsverläufe. Fig. 5 zeigt, dass der Verstärkungsverlauf im Frequenzbereich von 300 MHz bis 3000 MHz bei 24dB oder darüber liegt. Die erfindungsgemäße Schaltung zeigt ein konstantes Verstärkungsverhalten über ein Frequenzbereich von ca. 3 Oktaven, d.h. 300MHz-600MHz, 600MHz-1200MHz und 1200MHz-3200MHz. Gegenüber dem in Fig. 5 dargestellten Verstärkungsverlauf der 90°-Hybridkoppler weist die erfindungsgemäße Schaltung einen Breitbandengewinn von 1700 MHz bei 24 dB Verstärkung auf.

Mit der erfindungsgemäßen Schaltung ist somit eine Verstärkung von 24 dB über einen Frequenzbereich von 300 MHz bis 3000 MHz möglich, ohne dass zwischen einzelnen Verstärkerstufen umgeschaltet werden muss.

Selbstverständlich ist die erfindungsgemäße Schaltung nicht auf einen Arbeitsbereich von 300 MHz bis 3000 MHz beschränkt. Durch die Wahl geeigneter Transistorverstärkerstufen in Wide Bandgap Technologie sind Breitband-Verstärkerschaltungen mit einem Arbeitbereich von 100 MHz bis 5000 MHz möglich.

Anhand Fig. 7 wird noch einmal das Prinzip der Breitbanderweiterung erläutert. Fig. 7 stellt den Kopplungsverlauf des 90°-Hybridkopplers 1a aus Fig. 6 dar, der in dessen spezifiziertem Bereich von 2,0 GHz - 4,0 GHz bei 3,0 dB liegt (Typ Anaren Xinger 11306-3).

Die Kurve a) weist einen Kopplungsverlauf von 0 dB bis -3 dB auf. Der Arbeitsbereich des ersten Hybridkopplers 1 a für den Port A (Fig. 6) liegt somit zwischen 2,0 und 4,0 GHz. Die Kurve b) zeigt den Kopplungsverlauf von -20 dB bis maximal -3 dB. Der Arbeitsbereich des zweiten Hybridkopplers 1 b für den Port B liegt somit auch zwischen 2,0 und 4,0 GHz.

Die Darstellung zeigt somit die Größe der ausgekoppelten Leistung an den Ports A und B auf. Die Konsequenz der Nutzung des 90°-Hybridkopplers 1a ist, dass im Bereich 1. (100 MHz bis 2,0 GHz) in die Transistorverstärkerstufe 2a, auch als HF-Zug bezeichnet, mit dem Transistor 2a mehr Eingangsleistung eingekoppelt wird als in den HF-Zug mit Transistor 2b. Gleiches gilt für den Bereich 3. (> 4,0 GHz).

Im Bereich 2. (2,0 GHz bis 4,0 GHz) erhalten beide HF-Züge gleich viel HF-Eingangsleistung, da hier die Kopplung jeweils bei 3,0 dB liegt.

**Patentansprüche**

1. Schaltung zur Breitbandverstärkung umfassend einen Eingang HF_IN und einen Ausgang HF_OUT. wobei mit dem Eingang HF_IN der Schaltung ein erster 90°-Hybridkoppler (1a) und mit dem Ausgang HF_OUT der Schaltung ein zweiter 90°-Hybridkoppler (1 b) verbunden ist und wobei zwischen dem ersten und dem zweiten 90°-Hybridkoppler (1a, 1 b) zwei Verstärkerstufen (2a, 2b) parallel geschaltet sind,
   **dadurch gekennzeichnet, dass**
   es sich bei den 90°-Hybridkopplern (1a, 1b) um Hybridkoppler mit einem Arbeitsbereich von 1/n Oktaven zwischen einem unteren Frequenzwert und einem oberen Frequenzwert handelt, wobei $n \in \mathbb{N} \setminus \{0\}$ ist, d.h. n ist ein Element der natürlichen positiven ganzen Zahlen derart, dass der obere Frequenzwert größer als der untere Frequenzbereich und gleichzeitig kleiner als der 2-Fache Wert des unteren Frequenzwert ist, und wobei die Verstärkerstufen (2a, 2b) auf Transistoren basieren mit einer III-Nitrid-, oder SiC-, oder Diamant-Basis und wobei die Verstärkerstufen (2a, 2b) an die 90°-Hybridkoppler (1a, 1b) derart angepasst sind, dass in einem oder mehreren vorgebbaren Frequenzbereichen, in welchen die 90°-Hybridkoppler (1a, 1b) Dämpfungswerte von größer als 3 dB aufweisen, die Verstärkung der Verstärkerstufen (2a, 2b) diese Dämpfungswerte kompensieren, so dass am Ausgang HF_OUT der Schaltung die Verstärkung in einem Frequenzbereich von k Oktaven innerhalb eines vorgebbaren Wertebereichs liegt, wobei $k \in \mathbb{N} \setminus \{0\}$ ist.

2. Schaltung nach einem der vorangehenden Ansprüche,
**dadurch gekennzeichnet, dass**
es sich bei den 90°-Hybridkopplern (1a, 1b) um sowohl oberflächenmontierbare Bauelemente, als auch drop in oder Aluminium gehäuste Bauelemente, handeln kann.

## Claims

1. Circuit for broadband amplification, comprising an input HF_IN and an output HF_OUT, a first 90° hybrid coupler (la) being connected to the input HF_IN of the circuit and a second 90° hybrid coupler (1b) being connected to the output HF_OUT of the circuit, and two amplifier stages. (2a, 2b) being connected in parallel between the first and the second 90° hybrid coupler (1a, 1b),
**characterized in that**
the 90° hybrid couplers (1a, 1b) are hybrid couplers with an operating range of 1/n octaves between a lower frequency value and an upper frequency value, where $n \in \mathbb{N} \setminus \{0\}$, that is to say n is an element of the natural positive integers such that the upper frequency value is greater than the lower frequency range and at the same time smaller than double the value of the lower frequency value, and the amplifier stages (2a, 2b) being based on transistors with a III-nitride or SiC or diamond base, and the amplifier stages (2a, 2b) being matched to the 90° hybrid couplers (1a, 1b) in such a way that, in one or more predeterminable frequency ranges in which the 90° hybrid couplers (1a, 1b) have damping values greater than 3dB, these damping values compensate the amplification of the amplifier stages (2a, 2b) so that, at the output HF_OUT of the circuit, the amplification lies in a frequency range of k octaves within a predeterminable value range, where $k \in \mathbb{N} \setminus \{0\}$.

2. Circuit according to the preceding claim, **characterized in that** the 90° hybrid couplers (1a, 1b) may be both surface-mountable components and drop-in or aluminium-housed components.

## Revendications

1. Circuit d'amplification à large bande comprenant une entrée HF_IN et une sortie HF_OUT, un premier coupleur hybride de 90° (la) étant relié avec l'entrée HF_IN du circuit et un deuxième coupleur hybride de 90° (1b) avec l'entrée HF_OUT du circuit et deux étages amplificateurs (2a, 2b) étant branchés en parallèle entre le premier et le deuxième coupleur hybride à 90° (1a, 1b),
**caractérisé en ce que**
les coupleurs hybrides à 90° (1a, 1b) sont des coupleurs hybrides ayant une plage de fonctionnement de 1/n octaves entre une valeur de fréquence basse et une valeur de fréquence haute, avec $n \in \mathbb{N} \setminus \{0\}$, ce qui veut dire que n est un élément de l'ensemble des nombres entiers naturels positifs, de telle sorte que la valeur de fréquence haute est supérieure à la plage de fréquences basse et en même temps inférieure au double de la valeur de fréquence basse, et les étages amplificateurs (2a, 2b) étant basés sur des transistors à base d'un III-nitrure ou d'un SiC ou de diamant et les étages amplificateurs (2a, 2b) étant adaptés aux coupleurs hybrides à 90° (1a, 1b) de telle sorte que dans une ou plusieurs plages de fréquences à prédéfinir, dans laquelle(lesquelles) les coupleurs hybrides à 90° (1a, 1b) présentent des valeurs d'affaiblissement supérieures à 3 dB, l'amplification des étages amplificateurs (2a, 2b) compense ces valeurs d'affaiblissement de sorte qu'à la sortie HF_OUT du circuit, l'amplification dans une plage de fréquences de k octaves se trouve à l'intérieur d'une plage de valeurs à prédéfinir, avec $k \in \mathbb{N} \setminus \{0\}$.

2. Circuit selon la revendication précédente, **caractérisé en ce que** les coupleurs hybrides à 90° (1a, 1b) peuvent être aussi bien des composants à monter en surface que des composants de type « drop-in » ou en boîtier aluminium.

Fig. 1

Fig. 2

Fig. 3

Fig. 3b

Transistorkennlinie GaN-Transistor RFHIC
PTF240PD
10 Watt

Transistorkennlinie SiC-Transistor CREE
CRF24010
10 Watt

EP 1 936 802 B1

Fig. 3a

Fig. 4

Fig. 5

Fig. 6

Fig. 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 3709169 A1
- US 2004189380 A1

- DE 2807813 B1